# FASCICULE DE BREVET EUROPEEN

(11) **EP 0 871 979 B1**
(45) Date de publication et mention de la délivrance du brevet: **14.06.2006**
(21) Numéro de dépôt: 96934294.8
(22) Date de dépôt: 30.10.1996
(51) Int. Cl.: H01L 31/20, H01L 31/075

(54) **Procédé de fabrication d'une cellule photovoltaïque en silicium et cellule obtenue par la mise en oeuvre de ce procédé**
Verfahren zur Herstellung einer Silizium Solarzelle und so hergestellte Solarzelle
Method of manufacturing a silicon photovoltaic cell and cell obtained by this method

(30) Priorité: 02.01.1996 FR 9600105
(43) Date de publication de la demande: 21.10.1998
(73) Titulaire: UNIVERSITE DE NEUCHATEL, 2000 Neuchatel (CH)
(72) Inventeur: MEIER, Johann, CH-2035 Corcelles (CH); KROLL, Ulrich, CH-2035 Corcelles (CH)
(74) Mandataire: Gresset, Jean
(86) Numéro de dépôt international: PCT/CH1996/000382
(87) Numéro de publication internationale: WO 1997/024769

(56) Documents cités:
- AMORPHOUS SILICON TECHNOLOGY 1995- MATERIAL RESEARCH SOCIETY SYMPOSIUM PROCEEDINGS VOLUME 377, 18 - 21 Avril 1995, SAN FRANCISCO, CALIFORNIA, USA, pages 39-44, XP002016745 U. KROLL ET AL. : "Origin and incorporation mechanism for oxygen contaminants in a-Si:H and uc-Si:H films prepared by the very high frequency (70 MHz) glow discharge technique"
- 13TH EUROPEAN PHOTOVOLTAIC SOLAR ENERGY CONFERENCE, 23 - 27 Octobre 1995, NICE, FRANCE, pages 1445-1450, XP002016746 J. MEIER ET AL.: "The "micromorph" solar cells: a new way to high efficiency thin film silicon solar cells"
- APPLIED PHYSICS LETTERS, vol. 65, no. 7, 15 Août 1994, NEW YORK US, pages 860-862, XP000464558 J. MEIER ET AL.: "Complete microcristalline p-i-n solar cell-Crystalline or amorphous cell behavior?" cité dans la demande
- 1994 IEEE FIRST WORLD CONFERENCE ON PHOTOVOLTAIC ENERGY CONVERSION, 5 - 9 Décembre 1994, WAIKOLOA,HAWAII,USA, pages 409-412, XP000604456 J. MEIER ET AL.: "Intrinsic microcrystalline silicon (uc-Si:H)-A promising new thin film solar cell material" cité dans la demande
- 12TH EUROPEAN PHOTOVOLTAIC SOLAR ENERGY CONFERENCE, 11 - 15 Avril 1994, AMSTERDAM, NL, pages 1237-1240, XP002016747 J. MEIER ET AL.: "Microcristalline Silicon (uc-Si:H) P-I-N solar cells prepared by very high frequency glow discharge"
- 13TH EUROPEAN PHOTOVOLTAIC SOLAR ENERGY CONFERENCE, 23 - 27 Octobre 1995, NICE, FRANCE, pages 1638-1641, XP002016748 P. TORRES ET AL.: "Very low temperature epitaxial growth of <p>-type Silicon for solar cells"

## Description

La présente invention concerne un procédé de fabrication d'une cellule photovoltaïque au silicium. Elle concerne également une cellule photovoltaïque du type comportant au moins un substrat, une couche d'oxyde conducteur transparent, au moins une couche de silicium hydrogéné constituée d'une sous-couche de silicium hydrogéné dopé positivement, d'une sous-couche de silicium hydrogéné intrinsèque et d'une sous-couche de silicium hydrogéné dopé négativement.

Dans le domaine des cellules photovoltaïques notamment, on utilise couramment des couches de silicium amorphe comme couches photovoltaïquement actives. Ces couches présentent en particulier un inconvénient qui vient du fait qu'elles se dégradent lorsqu'elles sont soumises à une illumination. Cette dégradation est connue sous le nom de dégradation de Staebler-Wronski. Les cellules solaires utilisant ce matériau perdent rapidement une partie de leur rendement.

Les tentatives d'utilisation de silicium microcristallin, également appelé silicium nanocristallin, dans des cellules solaires ont presque toujours abouti à de mauvais résultats. En effet, le taux de défauts de ce type de couche est trop important pour permettre leur utilisation et seule une partie de l'épaisseur de la couche de silicium microcristallin participe à la collection des porteurs de charge. Le photocourant est alors faible et la cellule inintéressante. Ces défauts ont été considérés comme liés au matériau lui-même, celui-ci ayant donc souvent été jugé inutilisable.

Certaines études, publiées notamment dans "Appl. Phys. Lett. 65 (7), p. 860, 15 août 1994" et intitulées "Complete microcrystalline p-i-n solar cell - Crystalline or amorphous cell behaviour ?" de MM. Meier, Flückiger, Keppner et Shah, ont mis en évidence un phénomène de dopage involontaire. En effet, le dépôt d'une couche de silicium au moyen d'un procédé conventionnel tel qu'un dépôt par vaporisation connu sous l'abréviation CVD (Chemical Vapor Deposition) ou un dépôt par plasma en présence de silane, conduit à une couche légèrement dopée négativement. Ce dopage négatif donne une couche peu intéressante, voire inutilisable dans une cellule photovoltaïque.

Un procédé de dépôt a été tenté pour supprimer ce dopage négatif. II consiste à ajouter aux gaz de dépôt un gaz produisant un dopage positif de façon à compenser le dopage involontaire négatif de la couche de silicium microcristallin. Ce procédé est notamment décrit dans le document "IEEE first world Conference on Photovoltaic Energy Conversion, 5-9 Décembre 1994, p. 409-412, intitulé "Intrinsic microcrystalline silicon - A promising new thin film solar cell material" de MM. Meier, Dubail, Flückiger, Fischer. Keppner et Shah. Bien qu'il donne des résultats particulièrement intéressants, il est difficile à mettre en oeuvre de façon industrielle. En effet, le taux de gaz dopant à introduire dans la chambre de dépôt dépend d'un certain nombre de paramètres difficiles à maîtriser. Ces paramètres sont notamment la quantité de désorption de gaz de la chambre de dépôt, la vitesse du flux de gaz et la vitesse de dépôt de la couche. Ce procédé a permis de montrer la faisabilité d'une couche utilisant ce type de matériau. II a également permis de montrer l'intérêt que présente une telle couche pour la réalisation de cellules solaires mais, à cause des difficultés rencontrées pour maîtriser les paramètres du dépôt, il ne permet pas une application industrielle du procédé et reste uniquement un procédé de laboratoire.

Par ailleurs, le document "AMORPHOUS SILICON TECHNOLOGY 1995-MATERIAL RESEARCH SOCIEY SYMPOSIUM PROCEEDINGS, volume 377, 18-21 April 1995, San Francisco, California, USA, pages 39-44" de U. Kroll et al.décrit un procédé de fabrication d'une couche de silicium hydrogéné microcristallin, comportant une couche de silicium hydrogéné microcristallin intrinsèque contenant 2.10¹⁸ atomes d'oxygène par cm³. Cette réduction de la teneur en oxygène ne vise qu'à réduire la dégradation des propriétés de la couche de silicium induite par une exposition à la lumière. En revanche, les caractéristiques de densité de photocourant ne sont pas améliorées.

Dans le document "13^{TH} EUROPEAN PHOTOVOLTAIC SOLAR ENERGY CONFERENCE, 23-27 octobre 1995, Nice France, pages 1445-1450", J. Meier et al. décrivent une pluralité de cellules comportant, notamment, des couches de silicium microcristallin et de silicium amorphe. II n'est jamais fait mention d'une réduction de la teneur des couches en oxygène.

La présente invention se propose fournir un procédé industriel de dépôt d'une couche de silicium hydrogéné microcristallin ou nanocristallin intrinsèque, pour la réalisation d'une cellule photovoltaïque. La présente invention se propose également de réaliser, de façon industrielle, des cellules solaires présentant des caractéristiques électriques, notamment la densité de photocourant, et de stabilité particulièrement intéressantes par rapport aux cellules de l'art antérieur.

De façon plus précise, l'invention concerne un procédé de fabrication d'une cellule photovoltaïque selon la revendication 1.

Selon une variante, l'invention concerne un procédé de fabrication d'une cellule photovoltaïque selon la revendication2.

Selon un mode de réalisation avantageux, l'opération de dépôt de la couche de silicium comprend la formation d'un plasma du gaz de dépôt, soit par excitation par des radiofréquences, de préférence à une fréquence supérieure à 40 MHz, soit par excitation par des micro-ondes. En variante, l'opération de dépôt de la couche de silicium comprend le procédé de vaporisation chimique du gaz de dépôt.

Le gaz de dépôt est avantageusement composé de silane, d'hydrogène et/ou d'argon, la proportion de silane étant comprise entre 0,5% et 15%.

Selon un mode de réalisation particulier, l'étape de purification d'au moins un gaz de dépôt est précédée d'une étape de dégazage de la chambre.

Les buts fixés sont également atteints par une cellule photovoltaïque comportant au moins un substrat, une couche d'oxyde conducteur transparent, une conche de contact arrière et au moins une couche de silicium hydrogéné, caractérisée :
- en ce que ladite couche de silicium hydrogéné est constituée de silicium microcristallin ou nanochstallin et comprend une première sous-couche externe de silicium hydrogéné dopé positivement, une deuxième sous-couche externe de silicium hydrogéné dopé négativement et une troisième sous-couche de silicium hydrogéné située entre lesdites sous-couches externes, ladite troisième sous-couche étant intrinsèque et comprenant moins de 2x10¹⁹ atomes d'oxygène par cm³.

Selon un mode de réalisation préféré, la cellule photovoltaïque comporte une couche de silicium hydrogéné amorphe constituée d'une sous-couche de silicium hydrogéné amorphe dopé positivement, d'une sous-couche de silicium hydrogéné amorphe intrinsèque et d'une sous-couche de silicium hydrogéné amorphe dopé négativement, cette couche étant disposée entre la couche d'oxyde conducteur transparent et la couche de silicium hydrogéné microcristallin ou nanocristallin, la sous-couche de silicium hydrogéné microcristallin ou nanocristallin intrinsèque contenant moins de 2x10¹⁹ atomes d'oxygène par cm³.

Selon une autre forme de réalisation avantageuse, la cellule photovoltaïque comporte deux couches de silicium hydrogéné amorphe constituées chacune d'une sous-couche de silicium hydrogéné amorphe dopé positivement, d'une sous-couche de silicium hydrogéné amorphe intrinsèque et d'une sous-couche de silicium hydrogéné amorphe dopé négativement, ces deux couches de silicium hydrogéné amorphe étant disposées entre la couche d'oxyde conducteur transparent et la couche de silicium hydrogéné microcristallin ou nanocristallin, la sous-couche de silicium hydrogéné microcristallin ou nanocristallin intrinsèque contenant moins de 2x10¹⁹ atomes d'oxygène par cm³.

Selon une forme de réalisation avantageuse, la cellule photovoltaïque comporte, en outre, une couche réfléchissante arrière.

Selon encore une autre variante de réalisation, la cellule photovoltaïque comporte au moins deux couches de silicium hydrogéné constituées chacune d'une sous-couche de silicium hydrogéné dopé positivement, d'une sous-couche de silicium hydrogéné intrinsèque et d'une sous-couche de silicium hydrogéné dopé négativement, toutes les sous-couches dopées positivement étant connectées entre elles par au moins un canal latéral positif, toutes les sous-couches dopées négativement étant connectées entre elles par au moins un canal latéral négatif, chaque canal latéral positif étant disposé à proximité de et parallèlement à l'un des canaux latéraux négatifs, ces canaux latéraux étant séparés par un canal métallique, et les couches de silicium hydrogéné étant constituées de silicium hydrogéné microcristallin ou nanocristallin, les sous-couches de silicium hydrogéné microcristallin ou nanocristallin intrinsèque contenant moins de 2x10¹⁹ atomes d'oxygène par cm³.

Dans toutes ces réalisations, le substrat peut être soit transparent et disposé du côté de la couche d'oxyde conducteur transparent, soit disposé du côté opposé à la couche d'oxyde conducteur transparent.

La présente invention sera mieux comprise en référence à différents modes de réalisation non limitatifs et aux dessins annexés dans lesquels :
- la figure 1 illustre le dispositif de dépôt pour réaliser le procédé de fabrication selon la présente invention, et
- les figures 2 à 6 illustrent quatre modes de réalisation de cellules photovoltaïques selon la présente invention.

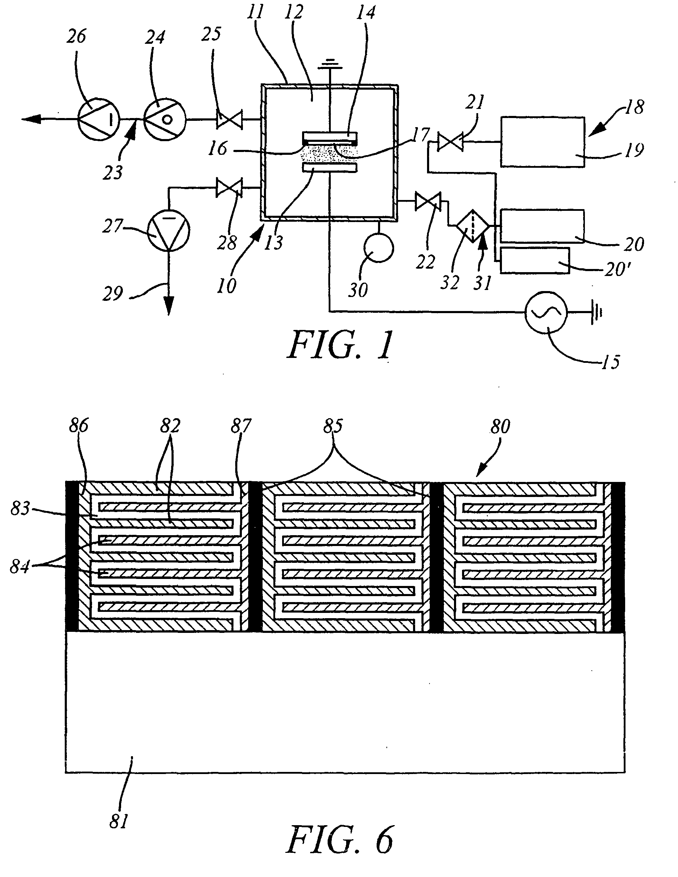

En référence à la figure 1, le dispositif 10 comporte un réacteur à plasma 11 constitué d'une chambre de dépôt 12 contenant une première électrode 13 raccordée par exemple à un générateur électrique de radiofréquences 15, et une seconde électrode 14 raccordée à la terre. Les électrodes sont disposées l'une en face de l'autre. La seconde électrode 14 comporte un support 16 pour fixer un substrat 17, constitué par exemple par une plaque de verre de faible épaisseur. Les deux électrodes ainsi que le substrat forment un élément capacitif permettant de créer un plasma par décharges électriques à haute fréquence entre les électrodes lorsqu'un gaz se trouve dans la chambre de dépôt 12.

Le dispositif 10 comporte en autre des moyens d'alimentation 18 en gaz comprenant en particulier un ou plusieurs réservoirs de gaz 19, 20 et 20' ainsi que des détendeurs 21 et 22 correspondants pour introduire différents gaz purs au sous forme de mélanges dans la chambre 12 du réacteur à travers une ou plusieurs vannes d'entrée. Le dispositif 10 comporte en outre des moyens 23 pour extraire les gaz de la chambre. Sur la figure 1, on a représenté une pompe turbomoléculaire 24 dont le côté aspiration est raccordé à la chambre 12 par l'intermédiaire d'une vanne 25, la pompe 24 étant suivie d'une première pompe primaire 26. Une seconde pompe primaire 27 est raccordée à la chambre 12 par une vanne 28, la sortie de cette pompe étant branchée sur un circuit 29 d'évacuation des gaz. On a représenté également un manomètre 30 indiquant la pression dans la chambre de dépôt 12. Par ailleurs, il est prévu divers moyens (non représentés) pour chauffer et pour refroidir les électrodes, le substrat et la chambre.

Enfin, le dispositif 10 comporte des moyens de purification 31 d'au moins un gaz introduit dans la chambre. Ces moyens de purification comportent en particulier un dispositif 32 d'élimination partielle de l'oxygène contenu dans le gaz utilisé pour le dépôt, quelle que soit la forme chimique de l'oxygène dans le gaz. De tels moyens de purification sont notamment commercialisés sous l'appellation Mono Torr ™ Silane Gas Purifier par la société SAES Pure Gas Inc.

Le procédé selon la présente invention se déroule pour l'essentiel de façon conventionnelle et comporte une étape de préparation du substrat, une étape de conditionnement du système et une étape de dépôt proprement dit.

Dans l'étape de préparation du substrat, ce substrat 17 qui peut être en verre, en métal ou en matière synthétique notamment, est découpé aux dimensions appropriées, puis nettoyé dans plusieurs bains d'eau et d'alcool. II est ensuite monté sur le support 16 et fixé à la seconde électrode 14 de la chambre de dépôt 12.

Dans l'étape de conditionnement du système, on fait le vide dans la chambre au moyen des différentes pompes 24, 26 et 27 jusqu'à l'obtention d'une pression inférieure à 10⁻⁴ Pa. On dégaze ensuite la chambre de dépôt 12 de façon à éliminer au maximum l'oxygène et ses composés contenus dans ses parois.

Dans l'étape de dépôt, qui est nouvelle par rapport aux étapes connues de l'art antérieur, les moyens d'alimentation 18 en gaz sont branchés de manière à délivrer dans la chambre de dépôt 12, de l'hydrogène pur et/ou de l'argon ainsi qu'un gaz comportant un composé de silicium tel que du silane (SiH₄).

Ce silane est dilué dans le mélange d'hydrogène et d'argon de telle façon que le mélange de ces trois gaz contienne une quantité de silane de l'ordre de 3%.

Il est également possible d'utiliser uniquement de l'hydrogène et du silane ou de l'argon et du silane. Toutefois, l'utilisation d'un mélange d'hydrogène, d'argon et de silane permet d'augmenter de façon importante la vitesse de dépôt de la couche microcristalline.

Les gaz délivrés par les moyens d'alimentation en gaz sont introduits dans les moyens de purification 31 avant leur introduction dans la chambre de dépôt, afin d'éliminer au maximum l'oxygène qu'ils contiennent, quelle que soit la forme chimique de l'oxygène. Cette purification est indispensable, faute de quoi, la couche obtenue sera inutilisable.

La vanne 28 est ouverte et la pompe 27 est actionnée de manière à maintenir une pression absolue p déterminée dans l'enceinte. Dès que la pression est stabilisée, on enclenche le générateur 15 pour produire un plasma entre les deux électrodes, et plus précisément entre le substrat 17 et la première électrode 13.

Il est important que le plasma soit plus ou moins confiné à la zone comprise entre les deux électrodes, grâce à un choix judicieux des paramètres tels que la pression, la distance et la densité de puissance électrique.

La fréquence du plasma utilisé pour le dépôt peut être quelconque. Toutefois, la vitesse de croissance de la couche est plus grande lorsque la fréquence est élevée. Comme les risques de contamination de la couche sont inversement proportionnels à la vitesse de dépôt, il est plus intéressant de déposer la couche sous une fréquence supérieure ou égale à 70 MHz. II est toutefois à noter que des procédés de dépôt utilisant une fréquence conventionnelle de 13,56 MHz donnent également des couches de bonne qualité.

En outre, d'autres procédés de dépôt connus peuvent également être utilisés. Ces procédés sont notamment le procédé de vaporisation chimique connu sous l'abréviation CVD (Chemical Vapor Déposition), un procédé utilisant un filament chauffé connu sous le nom de "technique hot-wire", un procédé de dépôt connu sous le nom de "Remote plasma" dans lequel un plasma est réalisé en dehors de la chambre de dépôt et introduit ultérieurement dans cette chambre, et un procédé dans lequel un plasma est crée par excitation par des micro-ondes.

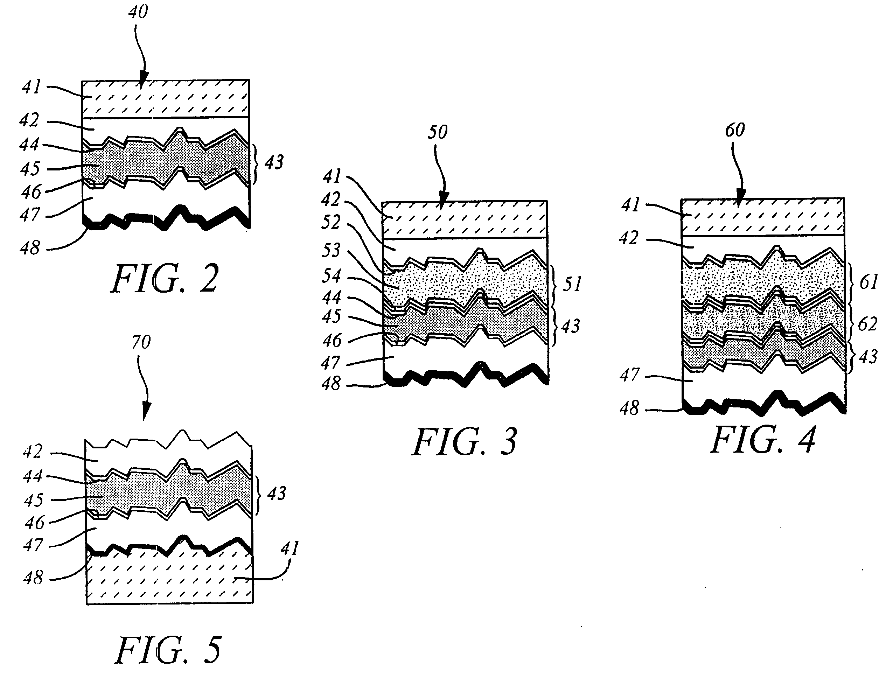

Les figures 2 à 5 illustrent quatre modes de réalisation de cellules photovoltaïques selon la présente invention. En particulier, la figure 2 illustre une cellule photovoltaïque 40 simple comportant un substrat transparent 41 sur lequel est déposée une couche d'oxyde conducteur transparent 42. Le substrat peut être du verre de marque Dow Corning ® ayant une épaisseur de 0,8 mm.

La couche suivante joue le rôle de couche photovoltaïquement active et est composée de trois "sous-couches" formant une jonction p-i-n. Cette couche 43 est composée de silicium hydrogéné microcristallin ou nanocristallin, la sous-couche 44 la plus proche du substrat 41 étant dopée positivement, la sous-couche intermédiaire 45 étant intrinsèque et la dernière sous-couche 46 étant dopée négativement. Cette couche microcristalline 43 comporte peu d'oxygène, ce qui permet de réaliser une couche de bonne qualité, utilisable par une cellule photovoltaïque. Selon des essais concrets, le nombre d'atomes d'oxygène par centimètre cube de matière déposée doit être inférieur à 2x10¹⁹ pour réaliser une cellule photovoltaïque dans laquelle toute l'épaisseur de la couche de silicium hydrogéné microcristallin est photovoltaïquement active. Une valeur typique du contenu d'oxygène dans la couche de silicium microcristallin déposée selon le procédé de la présente invention est de l'ordre de 10¹⁸ atomes par cm³. Le photocourant obtenu avec une telle cellule est alors supérieur à 20 mA/cm² pour un spectre normalisé A.M 1,5.

Finalement, la cellule comporte une couche de contact arrière 47 réalisée par exemple en oxyde de zinc, et une couche réfléchissante 48 en argent ou en aluminium agencée pour renvoyer les faisceaux incidents à travers la cellule.

La diminution de la quantité d'oxygène présente lors du dépôt de la couche de silicium hydrogéné microcristallin ou nanocristallin permet de diminuer de façon importante le nombre de défauts de cette couche créés par l'oxygène, ce qui permet de l'utiliser dans une cellule solaire. Les cellules comportant une telle couche se sont révélées nettement plus stables lorsqu'elles sont soumises à un rayonnement intense que les cellules conventionnelles à silicium amorphe.

La figure 3 illustre une cellule 50 ayant une structure générale connue sous le nom de structure "tandem". Comme dans la cellule illustrée par la figure 2, elle comporte un substrat 41, une couche d'oxyde conducteur transparent 42, une couche de silicium hydrogéné microcristallin 43 formée de trois sous-couches 44, 45 et 46 identiques aux sous-couches de la cellule de la figure 2, une couche de contact arrière 47 et une couche réfléchissante 48. Cette cellule comporte en outre une couche de silicium hydrogéné amorphe 51 constituée de trois sous-couches 52, 53 et 54 respectivement dopée positivement, intrinsèque et dopée négativement et formant une jonction p-i-n. Cette couche 51 est disposée entre la couche d'oxyde 42 et la couche microcristalline 43.

Dans une cellule utilisant une telle structure tandem, les deux couches 43 et 51 de silicium hydrogéné sont réalisées de façon à être sensibles à des longueurs d'ondes différentes de la lumière incidente. Cette sensibilité à certaines longueurs d'ondes dépend de la bande interdite du matériau constituant la couche. L'utilisation d'une couche de silicium amorphe et d'une couche de silicium microcristallin permet de réaliser facilement des couches de bandes interdites différentes permettant une bonne utilisation de !a lumière.

La figure 4 illustre un mode de réalisation d'une cellule photovoltaïque 60 triple comportant un substrat 41, une couche d'oxyde conducteur transparent 42, une première couche 61 de silicium hydrogéné amorphe similaire à !a couche 51 de la cellule 50 de la figure 3, une seconde couche 62 de silicium hydrogéné amorphe également similaire à la couche 51 de la figure 3 et une couche 43 de silicium hydrogéné microcristallin similaire à la couche 43 de la figure 3. Ces trois couches forment trois jonctions p-i-n et ont chacune une o bande interdite différente, de façon à être sensibles à différentes longueurs d'ondes et à utiliser de manière optimale la lumière pénétrant dans cette cellule photovoltaïque. La première couche 61 de silicium hydrogéné amorphe peut contenir du carbone, ce qui augmente la bande interdite par rapport à une couche similaire de silicium hydrogéné amorphe sans éléments supplémentaires. La seconde couche de silicium hydrogéné amorphe 62 peut contenir du germanium afin de diminuer la bande interdite de la couche.

La figure 5 illustre une cellule photovoltaïque 70 simple, du même type que celle de la figure 2, comportant les mêmes couches que la cellule 40. Une différence essentielle entre ces deux cellules vient du fait que la lumière ne traverse pas le substrat 41. Elle pénètre dans la cellule par le côté opposé au substrat. Celui-ci sert de support aux couches et peut donc être opaque. Ceci permet un plus grand choix du matériau qui le constitue. II peut notamment comporter du métal ou une matière synthétique ayant des caractéristiques physiques adéquates.

Comme la lumière doit toujours pénétrer dans une cellule photovoltaïque par la sous-couche dopée positivement, la première couche à déposer sur le substrat est une couche dopée négativement, alors que, dans les cas illustrés par les figures 2 à 4, cette couche est dopée positivement. La couche forme une jonction n-i-p dans le cas illustré par la figure 5.

La figure 6 est une vue en coupe transversale d'un mode de réalisation d'une cellule photovoltaïque 80 comportant un substrat 81 sur lequel sont déposées plusieurs couches 82, 83 et 84 de silicium microcristallin hydrogénées, respectivement dopées négativement (82), intrinsèques (83) et dopées positivement (84). Dans ce mode de réalisation, les couches formant les jonctions p-i-n sont disposées par piles, ces piles étant séparées par un canal métallique 85. D'autre part, toutes les couches 82 dopées négativement d'une même pile sont connectées entre elles par un canal latéral négatif 86. De manière similaire, toutes les couches 84 dopées positivement d'une même pile sont connectées entre elles par un canal latéral positif 87. Comme dans les modes de réalisation décrits ci-dessus, les couches de silicium intrinsèques sont déposées après élimination au moins partielle des molécules comprenant de l'oxygène. Ce mode de réalisation autorise un empilement important de couches formant des jonctions p-i-n.

La présente invention n'est pas limitée aux modes de réalisation décrits, mais s'étend à toute modification ou variante évidente pour l'homme du métier. En particulier, un autre dispositif de dépôt que celui décrit peut être utilisé pour autant que ce dispositif comporte des moyens pour diminuer la quantité d'oxygène dans le gaz de dépôt.

De même, l'utilisation d'une couche de silicium microcristallin n'est pas limitée aux cellules photovoltaïques décrites ci-dessus, mais s'étend à toute variante dans laquelle l'utilisation d'une telle couche présente des avantages, que ce soit du point de vue des caractéristiques techniques telles que le rendement ou des caractéristiques économiques telles que le coût de production.

Il est également possible d'utiliser la couche de silicium hydrogéné microcristallin intrinsèque "pauvre" en oxygène dans d'autres éléments que des cellules photovoltaïques. En particulier, une telle couche peut être utilisée dans des détecteurs tels que des détecteurs à infrarouge, des détecteurs optoélectroniques, des détecteurs à rayons X ou des détecteurs de position.

## Revendications

1. Procédé de fabrication d'une cellule photovoltaïque au silicium, **caractérisé en ce qu'**il comporte les opérations de :
- nettoyage d'un substrat transparent (41) muni d'un oxyde transparent conducteur (42),
- introduction du substrat dans une chambre de dépôt (42) ayant subi une étape préalable de mise sous vide ,
- purification, pour réduire sa teneur en molécules contenant de l'oxygène, d'au moins un des gaz constituant le gaz de dépôt, ledit gaz de dépôt contenant un composé de silicium, de l'hydrogène et/ou de l'argon ,
- introduction dudit gaz purifié dans la chambre de dépôt (12),
- dépôt sur le substrat (41) d'au moins une couche de silicium hydrogéné (43) constituée de silicium microcristallin ou nanocristallin, ladite couche comprenant, successivement depuis le côté substrat, une première sous-couche (44) de silicium hydrogéné dopé positivement, une deuxième sous-couche (45) de silicium hydrogéné intrinsèque, et une troisième sous-couche (46) de silicium hydrogéné dopé négativement, et
- dépôt d'une couche de contact arrière (47), et d'une couche réfléchissante (48),
ladite deuxième sous-couche intrinsèque (45) comprenant moins de 2x10¹⁹ atomes d'oxygène par cm³ comme résultat de ladite purification.

2. Procédé de fabrication d'une cellule photovoltaïque, **caractérisé en ce qu'**il comporte les opérations de :
- nettoyage d'un substrat (41) muni d'une couche réfléchissante (48) et d'une couche de contact arrière (47),
- introduction du substrat dans une chambre de dépôt (12) ayant subi une étape préalable de mise sous vide ,
- purification d'au moins un gaz de dépôt contenant un composé de silicium, de l'hydrogène et/ou de l'argon pour réduire sa teneur en oxygène,
- introduction dudit gaz purifié dans la chambre de dépôt (12),
- dépôt sur le substrat (41) d'au moins une couche de silicium hydrogéné (43) constituée de silicium microcristallin ou nanocristallin, ladite couche comprenant, successivement depuis le côté substrat, une première sous-couche (46) de silicium hydrogéné dopé négativement, une deuxième sous-couche (45) de silicium hydrogéné intrinsèque, et une troisième sous-couche (44) de silicium hydrogéné dopé positivement, et
- dépôt d'une couche d'oxyde conducteur transparent (42),
ladite deuxième sous-couche intrinsèque comprenant moins de 2x10¹⁹ atomes d'oxygène par cm³, comme résultat de ladite purification.

3. Procédé selon l'une des revendications 1 et 2, **caractérisé en ce que** l'opération de dépôt comprend la formation d'un plasma du gaz de dépôt.

4. Procédé selon la revendication 3, **caractérisé en ce que** le plasma est formé par excitation par des radiofréquences.

5. Procédé selon la revendication 4, **caractérisé en ce que** lesdites radiofréquences ont une fréquence supérieure à 40 MHz.

6. Procédé selon la revendication 3, **caractérisé en ce que** le plasma est formé par excitation par des micro-ondes.

7. Procédé selon l'une des revendications 1 et 2, **caractérisé en ce que** l'opération de dépôt comprend le procédé de vaporisation chimique du gaz de dépôt.

8. Procédé selon l'une des revendications précédentes, **caractérisé par** l'introduction dans la chambre de silane, d'hydrogène et/ou d'argon, la proportion de silane étant comprise entre 0,5% et 15%.

9. Procédé selon l'une des revendications 1 à 8, **caractérisé en ce qu'**il comprend, en outre, préalablement à l'étape de purification d'au moins un gaz de dépôt, une étape de dégazage de la chambre.

10. Cellule photovoltaïque comportant au moins un substrat (41), une couche d'oxyde conducteur transparent (42), une couche de contact arrière et au moins une couche de silicium hydrogéné (43), **caractérisée en ce que** ladite couche de silicium hydrogéné (43) est constituée de silicium microcristallin ou nanocristallin et comprend une première sous-couche externe (44) de silicium hydrogéné dopé positivement, une deuxième sous-couche externe (46) de silicium hydrogéné dopé négativement et une troisième sous-couche (45) de silicium hydrogéné située entre lesdites sous-couches externes, ladite troisième sous-couche étant intrinsèque et comprenant moins de 2x10¹⁹ atomes d'oxygène par cm³.

11. Cellule photovoltaïque selon la revendication 10, **caractérisée en ce qu'**elle comporte, en outre, une couche de silicium hydrogéné amorphe (51) constituée d'une sous-couche (52) de silicium hydrogéné amorphe dopé positivement, d'une sous-couche (53) de silicium hydrogéné amorphe intrinsèque et d'une sous-couche (54) de silicium hydrogéné amorphe dopé négativement, cette couche étant disposée entre la couche d'oxyde conducteur transparent (42) et la couche de silicium hydrogéné microcristallin ou nanocristallin (43).

12. Cellule photovoltaïque selon la revendication 10, **caractérisée en ce qu'**elle comporte deux couches de silicium hydrogéné amorphe (61, 62) constituées chacune d'une sous-couche de silicium hydrogéné amorphe dopé positivement, d'une sous-couche de silicium hydrogéné amorphe intrinsèque et d'une sous-couche de silicium hydrogéné amorphe dopé négativement, ces deux couches de silicium hydrogéné amorphe étant disposées entre la couche d'oxyde conducteur transparent et la couche de silicium hydrogéné microcristallin ou nanocristallin.

13. Cellule photovoltaïque selon l'une des revendications 10 à 12, **caractérisée en ce qu'**elle comporte en outre une couche réfléchissante arrière (48).

14. Cellule photovoltaïque selon la revendication 10, **caractérisée en ce qu'**elle comporte au moins deux couches de silicium hydrogéné constituées chacune d'une sous-couche (84) de silicium hydrogéné dopé positivement, d'une sous-couche (83) de silicium hydrogéné intrinsèque et d'une sous-couche (82) de silicium hydrogéné dopé négativement, **en ce que** toutes les sous-couches dopées positivement sont connectées entre elles par au moins un canal latéral positif (87), **en ce que** toutes les sous-couches dopées négativement sont connectées entre elles par au moins un canal latéral négatif (86), chaque canal latéral positif étant disposé à proximité de et parallèlement à l'un des canaux latéraux négatifs, ces canaux latéraux étant séparés par un canal métallique (85), et **en ce que** les couches de silicium hydrogéné sont constituées de silicium hydrogéné microcristallin ou nanocristallin, les sous-couches de silicium hydrogéné microcristallin ou nanocristallin (83) intrinsèque contenant moins de 2x10¹⁹ atomes d'oxygène par cm³.

15. Cellule photovoltaïque selon l'une des revendications 10 à 14, **caractérisée en ce que** le substrat (41) est transparent et est disposé du côté de la couche d'oxyde conducteur transparent (42).

16. Cellule photovoltaïque selon l'une des revendications 10 à 14, **caractérisée en ce que** le substrat (41) est disposé du côté opposé à la couche d'oxyde conducteur transparent (42).

## Claims

1. Method of manufacturing a silicon photovoltaic cell, **characterized in that** it comprises the operations of:
- cleaning a transparent substrate (41) provided with a transparent conductive oxide (42);
- introducing the substrate into a deposition chamber (12) that has undergone a prior step of creating a vacuum therein;
- purifying at least one of the constituent gases of the deposition gas, in order to reduce its content of oxygen-containing molecules, said deposition gas containing a silicon compound, hydrogen and/or argon;
- introducing said purified gas into the deposition chamber (12);
- depositing at least one hydrogenated silicon layer (43), consisting of microcrystalline or nanocrystalline silicon, on the substrate (41), said layer comprising, in succession from the substrate side, a first sublayer (44), made of positively doped hydrogenated silicon, a second sublayer (45), made of intrinsic hydrogenated silicon, and a third sublayer (46), made of negatively doped hydrogenated silicon; and
- depositing a rear contact layer (47) and a reflecting layer (48),
said intrinsic second sublayer (45) comprising less than 2 x 10¹⁹ oxygen atoms per cm³ as result of said purification.

2. Method of manufacturing a photovoltaic cell, **characterized in that** it comprises the operations of:
- cleaning a substrate (41) provided with a reflecting layer (48) and with a rear contact layer (47);
- introducing the substrate into a deposition chamber (12) that has undergone a prior step of creating a vacuum therein;
- purifying at least a deposition gas containing a silicon compound, hydrogen and/or argon in order to reduce its oxygen content;
- introducing said purified gas into the deposition chamber (12);
- depositing at least one hydrogenated silicon layer (43), consisting of microcrystalline or nanocrystalline silicon, on the substrate (41), said layer comprising, in succession from the substrate side, a first sublayer (46), made of negatively doped hydrogenated silicon, a second sublayer (45), made of intrinsic hydrogenated silicon, and a third sublayer (44), made of positively doped hydrogenated silicon; and
- depositing a layer (42) of transparent conductive oxide,
said intrinsic second sublayer comprising less than 2 × 10¹⁹ oxygen atoms per cm³, as a result of said purification.

3. Method according to either of Claims 1 and 2, **characterized in that** the deposition operation comprises the formation of a plasma of the deposition gas.

4. Method according to Claim 3, **characterized in that** the plasma is formed by excitation by radiofrequency radiation.

5. Method according to Claim 4, **characterized in that** said radiofrequency radiation has a frequency of greater than 40 MHz.

6. Method according to Claim 3, **characterized in that** the plasma is formed by microwave excitation.

7. Method according to either of Claims 1 and 2, **characterized in that** the deposition operation comprises the process of chemically vaporizing the deposition gas.

8. Method according to one of the preceding claims, **characterized by** the introduction of silane, hydrogen and/or argon into the chamber, the proportion of silane being between 0.5% and 15%.

9. Method according to one of Claims 1 to 8, **characterized in that** it further includes, prior to the step of purifying at least one deposition gas, a step of degassing the chamber.

10. Photovoltaic cell comprising at least one substrate (41), a layer (42) of transparent conductive oxide, a rear contact layer and at least one hydrogenated silicon layer (43), **characterized in that** said hydrogenated silicon layer (43) consists of microcrystalline or nanocrystalline silicon and comprises an outer first sublayer (44), made of positively doped hydrogenated silicon, an outer second sublayer (46), made of negatively doped hydrogenated silicon, and a third sublayer (45), made of hydrogenated silicon, lying between said outer sublayers, said third sublayer being intrinsic and comprising less than 2 x 10¹⁹ oxygen atoms per cm³.

11. Photovoltaic cell according to Claim 10, **characterized in that** it further includes an amorphous hydrogenated silicon layer (51) consisting of a positively doped amorphous hydrogenated silicon sublayer (52), an intrinsic amorphous hydrogenated silicon sublayer (53) and a negatively doped amorphous hydrogenated silicon sublayer (54), this layer being placed between the transparent conductive oxide layer (42) and the microcrystalline or nanocrystalline hydrogenated silicon layer (43).

12. Photovoltaic cell according to Claim 10, **characterized in that** it comprises two amorphous hydrogenated silicon layers (61, 62), each consisting of a positively doped amorphous hydrogenated silicon sublayer, an intrinsic amorphous hydrogenated silicon sublayer and a negatively doped amorphous hydrogenated silicon sublayer, these two amorphous hydrogenated silicon layers being placed between the transparent conductive oxide layer and the microcrystalline or nanocrystalline hydrogenated silicon layer.

13. Photovoltaic cell according to one of Claims 10 to 12, **characterized in that** it further includes a rear reflecting layer (48).

14. Photovoltaic cell according to Claim 10, **characterized in that** it comprises at least two hydrogenated silicon layers, each consisting of a positively doped hydrogenated silicon sublayer (84), an intrinsic hydrogenated silicon sublayer (83) and a negatively doped hydrogenated silicon sublayer (82), **in that** all the positively doped sublayers are connected together via at least one positive lateral channel (87), **in that** the negatively doped sublayers are connected together via at least one negative lateral channel (86), each positive lateral channel being placed in proximity and parallel to one of the negative lateral channels, these lateral channels being separated by a metal channel (85), and **in that** the hydrogenated silicon layers consist of microcrystalline or nanocrystalline hydrogenated silicon, the microcrystalline or nanocrystalline intrinsic hydrogenated silicon sublayers (83) containing less than 2 x 10¹⁹ oxygen atoms per cm³.

15. Photovoltaic cell according to one of Claims 10 to 14, **characterized in that** the substrate (41) is transparent and is placed on one side of the transparent conductive oxide layer (42).

16. Photovoltaic cell according to one of Claims 10 to 14, **characterized in that** the substrate (41) is placed on the opposite side from the transparent conductive oxide layer (42).

## Patentansprüche

1. Verfahren zum Herstellen einer Siliziumsolarzelle, **dadurch gekennzeichnet, dass** es die folgenden Schritte umfasst:
- Säubern eines durchsichtigen Substrats (41), das mit einem durchsichtigen leitfähigen Oxid (42) versehen ist,
- Einbringen des Substrats in eine Beschichtungskammer (12), die vorher einen Evakuierungsschritt erfahren hat,
- Reinigen mindestens eines der Gase, aus denen das Beschichtungsgas besteht, um dessen Gehalt an Molekülen zu senken, die Sauerstoff enthalten, wobei das Beschichtungsgas eine Siliziumverbindung, Wasserstoff und/oder Argon enthält,
- Einbringen des gereinigten Gases in die Beschichtungskammer (12),
- Aufbringen mindestens einer Schicht aus hydriertem Silizium (43), die aus mikrokristallinem oder nanokristallinem Silizium besteht, auf das Substrat (41), wobei die Schicht nacheinander von der Substratseite aus eine erste Teilschicht (44) aus hydriertem positiv dotiertem Silizium, eine zweite Teilschicht (45) aus eigenleitendem hydriertem Silizium und eine dritte Teilschicht (46) aus hydriertem negativ dotiertem Silizium umfasst, und
- Aufbringen einer hinteren Kontaktschicht (47) und einer reflektierenden Schicht (48),
wobei die zweite eigenleitende Teilschicht (45) als Ergebnis der Reinigung weniger als 2x10¹⁹ Sauerstoffatome je cm³ aufweist.

2. Verfahren zum Herstellen einer Solarzelle, **dadurch gekennzeichnet, dass** es die folgenden Schritte umfasst:
- Reinigen eines Substrats (41), das mit einer reflektierenden Schicht (48) und einer hinteren Kontaktschicht (47) versehen ist,
- Einbringen des Substrats in eine Beschichtungskammer (12), die vorher einen Evakuierungsschritt erfahren hat,
- Reinigen mindestens eines Beschichtungsgases, das eine Siliziumverbindung, Wasserstoff und/oder Argon enthält, um seinen Sauerstoffgehalt zu senken,
- Einbringen des gereinigten Gases in die Beschichtungskammer (12);
- Aufbringen mindestens einer Schicht aus hydriertem Silizium (43), die aus mikrokristallinem oder nanokristallinem Silizium besteht, auf das Substrat (41), wobei die Schicht nacheinander von der Substratseite aus eine erste Teilschicht (46) aus hydriertem negativ dotiertem Silizium, eine zweite Teilschicht (45) aus eigenleitendem hydriertem Silizium und eine dritte Teilschicht (44) aus hydriertem positiv dotiertem Silizium umfasst, und
- Aufbringen einer Schicht aus einem leitfähigen durchsichtigen Oxid (42),
wobei die zweite eigenleitende Teilschicht als Ergebnis der Reinigung weniger als 2x10¹⁹ Sauerstoffatome je cm³ aufweist.

3. Verfahren nach einem der Ansprüche 1 und 2, **dadurch gekennzeichnet, dass** der Vorgang des Aufbringens die Erzeugung eines Beschichtungsgasplasmas umfasst.

4. Verfahren nach Anspruch 3, **dadurch gekennzeichnet, dass** das Plasma durch Hochfrequenzanregung erzeugt wird.

5. Verfahren nach Anspruch 4, **dadurch gekennzeichnet, dass** diese Hochfrequenzen eine Frequenz von über 40 MHz aufweisen.

6. Verfahren nach Anspruch 3, **dadurch gekennzeichnet, dass** das Plasma durch Mikrowellenanregung erzeugt wird.

7. Verfahren nach einem der Ansprüche 1 und 2, **dadurch gekennzeichnet, dass** der Vorgang des Aufbringens das Verfahren der chemischen Gasphasenabscheidung mit dem Beschichtungsgas umfasst.

8. Verfahren nach einem der vorhergehenden Ansprüche, das durch das Einbringen von Silan, Wasserstoff und/oder Argon in die Kammer **gekennzeichnet** ist, wobei der Anteil von Silan zwischen 0,5% und 15% liegt.

9. Verfahren nach einem der Ansprüche 1 bis 8, **dadurch gekennzeichnet, dass** es unter anderem vor dem Schritt des Reinigens mindestens eines Beschichtungsgases einen Schritt des Entgasens der Kammer umfasst.

10. Solarzelle, die mindestens ein Substrat (41), eine Schicht aus einem leitfähigen durchsichtigen Oxid (42), eine hintere Kontaktschicht und mindestens eine Schicht aus hydriertem Silizium (43) umfasst, **dadurch gekennzeichnet, dass** die Schicht aus hydriertem Silizium (43) aus mikrokristallinem oder nanokristallinem Silizium besteht und eine erste äußere Teilschicht (44) aus hydriertem positiv dotiertem Silizium, eine zweite äußere Teilschicht (46) aus hydriertem negativ dotiertem Silizium und eine dritte Teilschicht (45) aus hydriertem Silizium umfasst, die zwischen den äußeren Teilschichten liegt, wobei die dritte Teilschicht eigenleitend ist und weniger als 2x10¹⁹ Sauerstoffatome je cm³ aufweist.

11. Solarzelle nach Anspruch 10, **dadurch gekennzeichnet, dass** sie unter anderem eine Schicht aus hydriertem amorphem Silizium (51) aufweist, die aus einer Teilschicht (52) aus hydriertem amorphem positiv dotiertem Silizium, einer Teilschicht (53) aus hydriertem amorphem eigenleitendem Silizium und einer Teilschicht (54) aus hydriertem amorphem negativ dotiertem Silizium besteht, wobei diese Schicht zwischen der Schicht aus einem leitfähigen durchsichtigen Oxid (42) und der Schicht aus hydriertem mikrokristallinem oder nanokristallinem Silizium (43) angeordnet ist.

12. Solarzelle nach Anspruch 10, **dadurch gekennzeichnet, dass** sie zwei Schichten aus hydriertem amorphem Silizium (61, 62) aufweist, die jeweils aus einer Teilschicht aus hydriertem amorphem positiv dotiertem Silizium, einer Teilschicht aus hydriertem amorphem eigenleitendem Silizium und einer Teilschicht aus hydriertem amorphem negativ dotiertem Silizium besteht, wobei diese beiden Schichten aus hydriertem amorphem Silizium zwischen der Schicht aus einem leitfähigen durchsichtigen Oxid und der Schicht aus hydriertem mikrokristallinem oder nanokristallinem Silizium angeordnet sind.

13. Solarzelle nach einem der Ansprüche 10 bis 12, **dadurch gekennzeichnet, dass** sie unter anderem eine hintere reflektierende Schicht (48) aufweist.

14. Solarzelle nach Anspruch 10, **dadurch gekennzeichnet, dass** sie mindestens zwei Schichten aus hydriertem Silizium aufweist, die jeweils aus einer Teilschicht (84) aus hydriertem positiv dotiertem Silizium, einer Teilschicht (83) aus hydriertem eigenleitendem Silizium und einer Teilschicht (82) aus hydriertem negativ dotiertem Silizium besteht, **dadurch**, **dass** alle positiv dotierten Teilschichten miteinander durch mindestens einen positiven Seitenkanal (87) verbunden sind, **dadurch, dass** alle negativ dotierten Teilschichten miteinander durch mindestens einen negativen Seitenkanal (86) verbunden sind, wobei jeder positive Seitenkanal in der Nähe von und parallel zu einem der negativen Seitenkanäle angeordnet ist, wobei diese Seitenkanäle durch einen Metallkanal (85) getrennt sind, und **dadurch, dass** die Schichten aus hydriertem Silizium aus hydriertem mikrokristallinem oder nanokristallinem Silizium bestehen, wobei die Teilschichten aus hydriertem eigenleitendem mikrokristallinem oder nanokristallinem Silizium (83) weniger als 2x10¹⁹ Sauerstoffatome je cm³ enthalten.

15. Solarzelle nach einem der Ansprüche 10 bis 14, **dadurch gekennzeichnet, dass** das Substrat (41) durchsichtig ist und auf der Seite der Schicht aus einem leitfähigen durchsichtigen Oxid (42) angeordnet ist.

16. Solarzelle nach einem der Ansprüche 10 bis 14, **dadurch gekennzeichnet, dass** das Substrat (41) auf der gegenüberliegenden Seite der Schicht aus einem leitfähigen durchsichtigen Oxid (42) angeordnet ist.
